Europäisches Patentamt

European Patent Office

Office européen des brevets

(11) Veröffentlichungsnummer: **0 522 523 A2**

# (12) EUROPÄISCHE PATENTANMELDUNG

(21) Anmeldenummer: **92111571.3**

(22) Anmeldetag: **08.07.92**

(51) Int. Cl.5: **G01N 17/00**, H01L 21/66

(30) Priorität: **12.07.91 DE 4123228**

(43) Veröffentlichungstag der Anmeldung:
**13.01.93 Patentblatt 93/02**

(84) Benannte Vertragsstaaten:
**AT DE FR GB IT NL**

(71) Anmelder: **SIEMENS AKTIENGESELLSCHAFT**
**Wittelsbacherplatz 2**
**W-8000 München 2(DE)**

(72) Erfinder: **Proksche, Harald, Dipl.-Chem.**
**Bäckergasse 14**
**W-8900 Augsburg(DE)**
Erfinder: **Ross, Detlef, Dr.rer.nat.**
**Magdalenenweg 30**
**W-8011 Kirchheim(DE)**

(54) **Verfahren zur Bestimmung der Dotierstoffkonzentration.**

㊝ Die Ätzrate der zu messenden Schicht wird nacheinander in zwei verschiedenen Ätzlösungen bestimmt, in denen die dotierte Schicht qualitativ unterschiedliches Ätzverhalten zeigt, wobei in einem Verfahrensschritt eine wässrige, mit Ammoniumfluorid gepufferte Flußsäurelösung, und in einem anderen Verfahrensschritt eine wässrige Flußsäurelösung als Ätzlösung zur Bestimmung der zugehörigen Ätzrate verwendet wird. In einem abschließenden Verfahrensschritt wird die Konzentration der Dotierstoffe durch Vergleich der beiden Ätzraten, die unterschiedliche Abhängigkeit von der Konzentration der Dotierstoffe aufweisen, eindeutig ermittelt.

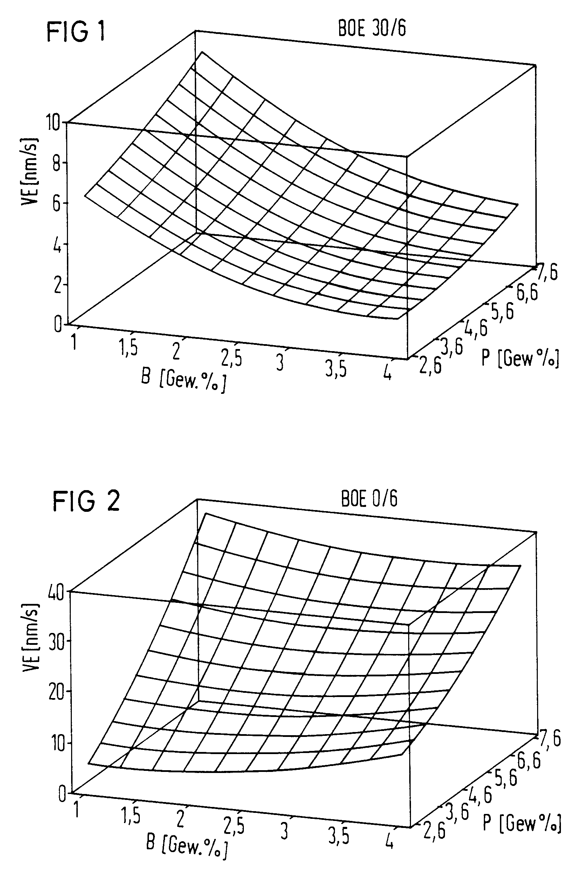

FIG 2      BOE 0/6

EP 0 522 523 A2

Die Erfindung betrifft ein verfahren zur Dotierstoffkonzentrationsbestimmung mittels Ätzratenbestimmung in insbesondere borhaltigen Phosphorsilikatglasschichten für integrierte Halbleiterschaltungen.

Phosphorhaltige Silikatglas(PSG-)schichten finden vielseitige Verwendung bei der Herstellung von hochintegrierten Halbleitern. Sie werden beispielsweise als Isolations- und Passivierungsschichten, als Diffusionsquellen zur Erzeugung von dotierten Bereichen in Siliziumsubstraten und insbesondere auch zum Planarisieren durch Verfließen des Phosphorglases, d. h. zur Schaffung einer möglichst idealen Topographie für die Aluminiumleitbahnen, eingesetzt. Um einen solchen Verfließschritt bei prozeßtechnisch tragbaren Temperaturen durchführen zu können, muß das Silikatglaszusätze enthalten, die Erweichungspunkt herabsetzen. In der Praxis werden hierbei als Dotierstoffe Phosphor und insbesondere Bor und Phosphor verwendet, die bereits bei der Schichtabscheidung in das Silikatglas mit eingebaut werden. Borphosphorsilikatglas (BPSG) wird im übrigen häufig auch wegen seiner höheren chemischen Stabilität gegenüber Luftfeuchtigkeit bevorzugt. Den jeweiligen vorteilen derartiger PSG-Schichten steht jedoch das Erfordernis einer genauen Kontrolle der Massenanteile, d. h. der Konzentration der Dotierstoffe Bor und Phosphor in den Schichten gegenüber. Die Dotierstoffkonzentrationsbestimmung stellt einen so wichtigen Kontrollschritt bei der Fertigung dar, daß üblicherweise jede Produktionscharge mit Hilfe eines Testwafers kontrolliert wird.

Bisher wird die Dotierstoffkonzentrationsbestimmung entweder mittels einer Infrarotmessung, oder mittels einer Röntgenfluoreszenzanalyse durchgeführt. Die erstgenannte Methode ist jedoch nur dann zuverlässig, wenn bestimmte Voraussetzungen wie Lagerzeit, definiertes Prozeßfenster, Untergrund usw. beachtet werden. Die Röntgenfluoreszensanalyse andererseits hat den Nachteil eines großen Platzbedarfes und hoher Investition- und Folgekosten. Beide bisher bekannten Meßmethoden sind immer auf ein sehr kleines Konzentrationsfenster für die Dotierstoffe zugeschnitten und somit unproblematisch immer nur im Rahmen eines speziellen Abscheideverfahrens bzw. eines speziellen Anlagentyps zu verwenden.

Es ist im übrigen hinsichtlich von Silikatglasschichten für höchstintegrierte Schaltungen aus "Principles of Wet Chemical Processing in ULSI Microfabrication", H. Kikyuama, IEEE Transactions On Semiconductor Manufacturing, vol. 4, no. 1, February 1991, Seite 26 bis 34 auch bekannt, eine naßchemische Ätzung zur Strukturierung oder Säuberung des Siliziumwafers mittels einer Ätzlösung vorzunehmen, die Wasser, Flußsäure (HF) und Ammoniumfluorid ($NH_4F$) enthält. Bei der Ätzung von Silikatglasschichten auf Siliziumhalbleitersubstraten ist es unbedingt notwendig, die wässrige Flußsäurelösung mit einem relativ hohen Anteil an Ammoniumfluorid zu puffern, um Probleme mit der Haftung des Fotolacks und mit seiner Erosion durch die Flußsäure zu vermeiden. Im genannten Aufsatz wird auch eine Variation des Anteils an Ammoniumfluorid im Hinblick auf bessere Benetzbarkeit und gleichmäßige Ätzung undotierten Silikatglases untersucht. Das Ätzverhalten dotierter Silikatglasschichten und das Problem der Bestimmung der Dotierstoffkonzentration wird im genannten Aufsatz nicht angesprochen.

Es ist die Aufgabe der Erfindung, ein einfaches und zuverlässiges Verfahren zur Bestimmung der Konzentration von Dotierstoffen in insbesondere borhaltigen PSG-Schichten anzugeben, das insbesondere nicht auf einen engen Dotierstoffkonzentrationsbereich beschränkt ist.

Die erfindungsgemäße Aufgabe wird durch ein Verfahren der eingangs genannten Art mit folgenden Merkmalen gelöst:

- die Ätzrate der zu messenden Schicht wird nacheinander in zwei verschiedenen Ätzlösungen bestimmt, in denen die dotierte Schicht qualitativ unterschiedliches Ätzverhalten zeigt,
- wobei in einem Verfahrensschritt eine wässrige, mit Ammoniumfluorid gepufferte Flußsäurelösung,
- und in einem anderen Verfahrensschritt eine wässrige Flußsäurelösung als Ätzlösung zur Bestimmung der zugehörigen Ätzrate verwendet wird;
- in einem abschließenden Verfahrensschritt wird die Konzentration der Dotierstoffe durch Vergleich der beiden Ätzraten, die unterschiedliche Abhängigkeit von der Konzentration der Dotierstoffe aufweisen, eindeutig ermittelt.

Im folgenden wird mit VE die Ätzrate der PSG-Schicht gemessen in nm/s und mit (B) und (P) die zu bestimmende Konzentration von Bor bzw. Phosphor, jeweils in Gewichtsprozent, bezeichnet. Für das Verhältnis Ammoniumfluorid-Konzentration/Flußsäure-Konzentration (jeweils in Gewichtsprozent) wird die Abkürzung BOE (Buffered Oxide Etch) verwendet.

Weitere Ausgestaltungen und Weiterbildungen der Erfindung gehen aus den Unteransprüchen, sowie nachfolgend aus der anhand der Figuren 1 und 2 gegebenen Beschreibung hervor. Es zeigen

FIG 1     ein Diagramm, in dem die Ätzrate in einer gepufferten Ätzlösung in Abhängigkeit von den beiden Konzentrationsvariablen (P) und (B) perspektivisch als Hyperfläche dargestellt ist,

FIG 2     eine zu FIG 1 analoge Darstellung der Ätzrate in ungepufferter Flußsäurelösung.

Die Erfindung macht sich das sehr differenzierte Ätzverhalten der mit Phosphor und mit Bor und Phosphor dotierten Siliziumoxide in Flußsäurelösungen mit unterschiedlichen Anteilen an Ammoniumfluorid zunutze, um mit Hilfe der Ätzraten eine quantitative Aussage über die Dotierstoffkonzentration zu gewinnen.

2

Das Ätzverhalten in Lösungen mit sehr niedriger Ammoniumfluorid-Konzentration ist bisher nicht untersucht worden, da, unabhängig von der Dotierung, bei den üblichen Ätzanwendungen ein mittlerer bis hoher Ammoniumfluoridanteil erforderlich ist, um Unterätzungen zu vermeiden. Eine Bestimmung der Dotierstoffkonzentration aus Ätzraten, die aus zwei mit unterschiedlichem $NH_4F$-Anteil gepufferten Ätzlösungen gewonnen wurden, ist nicht ohne weiteres möglich, da sie im Regelfall nicht zu eindeutigen Ergebnissen führt. Beispielsweise führt ein graphischer Vergleich der beiden Ätzraten zu einem verschmierten, oder zu überhaupt keinem Schnittpunkt der den Konzentrationen (P) und (B) zugeordneten Kurven. Das erfindungsgemäße Verfahren hingegen eröffnet einerseits die Möglichkeit einer vereinfachten und eindeutigen Bestimmung der Konzentration von Phosphor in PSG-Schichten und andererseits, ohne daß eine Wiederholung von Verfahrensschritten oder gar die Durchführung eines weiteren Meßverfahrens notwendig wäre, die gleichzeitige Konzentrationsbestimmung von Bor und Phosphor in BPSG-Schichten.

Die Dotierstoffkonzentration läßt sich bestimmen, indem die VE der zu untersuchenden Schicht einmal in mit Wasser verdünnter und mit Ammoniumfluorid gepufferter Flußsäure und einmal in mindestens nahezu reiner, mit Wasser verdünnter Flußsäure gemessen wird. FIG 1 (für BOE 30/6) und FIG 2 (für BOE 0/6) zeigen jeweils in perspektivischer Darstellung die von den beiden Variablen (B) und (P) abhängigen Ätzratenwerte VE. Durch Aufsuchen des Schnittpunktes der in FIG 1 und der in FIG 2 dargestellten Hyperflächen werden (P) und (B) gleichzeitig eindeutig bestimmt. Der Grund für die allgemeine Existenz eines eindeutigen Schnittpunktes ist vor allem darin zu suchen, daß die Ätzrate VE, wie in FIG 2 erkennbar, in ungepufferter Flußsäure mit Zunahme der Bor-Konzentration unerwarteterweise ansteigt. Durch Variation der Konzentrationen der Ätzlösungen lassen sich Schichten in einem weiten Dotierstoffkonzentrationsbereich bestimmen. Dazu ist es in der Praxis oft am einfachsten, die beiden gemessen Ätzraten mittels zweier vorher aufgenommener Kontourplots, in denen die VE-Werte als Kurve gegen die Phosphor- und Borkonzentration aufgetragen sind, zu vergleichen. Dies kann insbesondere durch Übereinanderlegen der beiden Kontourplots und Bestimmung eines eindeutigen Kurvenschnittpunktes geschehen.

Eine andere Möglichkeit der Bestimmung der Dotierung ergibt sich daraus, daß sich die Ätzraten von BPSG-Schichten sehr gut durch die folgende mathematische Gleichung annähern lassen:

$$VE((P), (B)) = K + a(P) + b(B) + c(P^2) + d(B^2) + e(B)(P)$$

Die für die Konzentrationen der jeweiligen Ätzlösung charakteristischen Parameter K, a, b, c, d und e lassen sich vorweg aus den Messungen bestimmen und die unbekannten Konzentrationen von Bor und Phosphor anschließend durch Auswertung der obigen, jeweils einmal für eine gepufferte und für eine ungepufferte Flußsäurelösung aufgestellten Gleichung auswerten. Es ergeben sich beispielsweise die beiden Gleichungen,

$$VE = 9{,}295 + 0{,}228(P) - 4{,}225(B) + 0{,}045(P^2) + 0{,}601(B^2) - 0{,}104(P)(B) \text{ für BOE 30/6;}$$

$$VE = -0{,}889 + 1{,}057(P) - 0{,}454(B) + 0{,}187(P^2) + 0{,}464(B^2) - 0{,}226(B)(P) \text{ für BOE 0/6;}$$

wobei die gewählten BOE-Werte geeignet sind für die Bestimmung von Konzentrationen in den Bereichen 2 < (B) < 3 und 5 < (P) < 7.

Bei den Versuchen mit aus einer Mach APGVD-Anlage stammenden Substratscheiben konnten für die verschiedenen Ätzlösungen (bei 24° C) folgende Werte bestimmt werden:

3

| BOE | K | a | b | c | d | e |
|---|---|---|---|---|---|---|
| 0/2 | -0,474 | 0,527 | -0.153 | 0,120 | 0,221 | -0,119 |
| 0,66/2 | 1,879 | -0,296 | 0,196 | 0,198 | 0,087 | -0,103 |
| 1/2 | 1,155 | 0,424 | -0,390 | 0,160 | 0,270 | -0,237 |
| 2/2 | 1,423 | 0,777 | -0,695 | 0,118 | 0,296 | -0,289 |
| 5/2 | 3,435 | 0,728 | -1,757 | 0,066 | 0,372 | -0,229 |
| 0/6 | -4,237 | 3,383 | -0,799 | 0,386 | 1,135 | -0,825 |
| 2/6 | 1,582 | 3,074 | -2,169 | 0,431 | 1,120 | -1,228 |
| 5/6 | 5,625 | 3,657 | -5,103 | 0,298 | 1,491 | -1,266 |
| 10/6 | 10,421 | 3,354 | -7,423 | 0,116 | 1,558 | -0,948 |
| 30/6 | 9,295 | 0,228 | -4,225 | 0,045 | 0,601 | -0,104 |
| 0/3 | -0,889 | 1,057 | -0,454 | 0,187 | 0,464 | -0,226 |

Die für die Durchführung des erfindungsgemäßen Verfahrens wichtige Messung der Ätzrate läßt sich beispielsweise durch eine Schichtdickenmessung vor der Ätzung, eine anschließende Ätzung von genau bestimmter Zeitdauer und eine nachfolgende Schichtdickenmessung verwirklichen, wobei sich die Ätzrate einfach aus der Schichtdickendifferenz und der Ätzzeit bestimmen läßt. Wesentlich einfacher allerdings gestaltet sich eine mit Hilfe eines Ätzratenmeßgerätes vorgenommene Messung. Dabei wird der Wafer mit der zu messenden PSG-Schicht in ein Becken mit Ätzlösung getaucht und der Ätzabtrag interferometrisch verfolgt. Nach der Ätzung wird die Ätzrate vom Gerät angezeigt. Mit einem deratigen, an sich bekannten Gerät lassen sich Ätzraten bis zu 30 nm/s sehr genau und bequem messen.

**Patentansprüche**

1. Verfahren zur Dotierstoffkonzentrationsbestimmung mittels Ätzratenbestimmung in insbesondere borhaltigen Phosphorsilikatglasschichten für integrierte Halbleiterschaltungen mit folgenden Merkmalen:
    - die Ätzrate der zu messenden Schicht wird nacheinander in zwei verschiedenen Ätzlösungen bestimmt, in denen die dotierte Schicht qualitativ unterschiedliches Ätzverhalten zeigt,
    - wobei in einem Verfahrensschritt eine wässrige, mit Ammoniumfluorid gepufferte Flußsäurelösung,
    - und in einem anderen Verfahrensschritt eine wässrige Flußsäurelösung als Ätzlösung zur Bestimmung der zugehörigen Ätzrate verwendet wird;
    - in einem abschließenden Verfahrensschritt wird die Konzentration der Dotierstoffe durch Vergleich der beiden Ätzraten, die unterschiedliche Abhängigkeit von der Konzentration der Dotierstoffe aufweisen, eindeutig ermittelt.

2. Verfahren nach Anspruch 1, bei dem die Konzentration von Phosphor in Phosphorsilikatglasschichten bestimmt wird.

3. Verfahren nach Anspruch 1, bei dem gleichzeitig die Konzentration von Bor und Phosphor in Borphosphorsilikatglas-Schichten bestimmt wird.

4. Verfahren nach einem der Ansprüche 1 bis 3, bei dem durch Variation der Konzentrationen der Ätzlösungen Schichten in einem weiten Dotierstoffkonzentrationsbereich bestimmt werden.

5. Verfahren nach Anspruch 4, bei dem eine gepufferte Flußsäurelösung mit einem Verhältnis der Konzentrationen Ammoniumfluorid/Flußsäure von etwa 0,66/2 bis etwa 30/6 Gewichtsprozent als eine, und bei dem eine etwa 2 bis 6 gewichtsprozentige, nahezu reine Flußsäure als andere Ätzlösung verwendet werden.

6. Verfahren nach einem der Ansprüche 3 bis 5, bei dem die funktionale Abhängigkeit der Ätzrate VE von den variablen Gewichtsprozentkonzentrationen (P) und (B) der Dotierstoffe Phosphor bzw. Bor durch die mathematische Gleichung

$$VE((P),(B)) = K + a(P) + b(B) + c(P^2) + d(B^2) + e(B)(P)$$

mit für die Konzentrationen der Ätzlösung charakteristischen Parametern K, a, b, c, d und e angenähert wird und bei dem die unbekannten Konzentrationen von Bor und Phosphor durch Auswertung der beiden Gleichungen für die in den beiden Ätzlösungen gemessenen Ätzraten ermittelt werden.

7. Verfahren nach einem der Ansprüche 3 bis 5, bei dem die beiden gemessenen Ätzraten mittels zweier vorher aufgenommener Kontourplots, in denen Ätzratenwerte als Kurve gegen die Phosphor- und Borkonzentration aufgetragen sind, verglichen werden, insbesondere durch Übereinanderlegen der beiden Kontourplots und Bestimmung eines eindeutigen Kurvenschnittpunktes.

8. Verfahren nach einem der Ansprüche 1 bis 7, bei dem vor den genannten Verfahrensschritten die Größenordnung der Ätzrate mittels einer weiteren Ätzlösung bestimmt wird.

9. Verfahren nach einem der Ansprüche 1 bis 8, bei dem die Ätzrate jeweils durch Messung der Ätzzeit und der zugehörigen Schichtdickendifferenz bestimmt wird.

10. Verfahren nach einem der Ansprüche 1 bis 8, bei dem die Ätzrate mittels eines Ätzratenmeßgerätes bestimmt wird, wobei der Ätzabtrag in der Ätzlösung interferometrisch verfolgt wird.

EP 0 522 523 A2

FIG 1    BOE 30/6

FIG 2    BOE 0/6

6